(19) Europäisches Patentamt
European Patent Office
Office européen des brevets

(11) **EP 3 325 411 B1**

(12) **FASCICULE DE BREVET EUROPEEN**

(45) Date de publication et mention de la délivrance du brevet:
**08.05.2019 Bulletin 2019/19**

(21) Numéro de dépôt: **16757280.9**

(22) Date de dépôt: **19.07.2016**

(51) Int Cl.:
*C01G 51/00* [(2006.01)]   *H01L 35/16* [(2006.01)]

(86) Numéro de dépôt international:
**PCT/FR2016/051849**

(87) Numéro de publication internationale:
**WO 2017/013348 (26.01.2017 Gazette 2017/04)**

(54) **MATÉRIAU THERMOÉLECTRIQUE À BASE DE SULFURE DE COBALT ET D'ANTIMOINE DOPÉ DE TYPE N**

THERMOELEKTRISCHES MATERIAL AUF DER BASIS VON N-DOTIERTEM KOBALTANTIMONSULFID

THERMOELECTRIC MATERIAL BASED ON N-TYPE DOPED COBALT ANTIMONY SULPHIDE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.07.2015 FR 1556861**

(43) Date de publication de la demande:
**30.05.2018 Bulletin 2018/22**

(73) Titulaire: **IMRA Europe SAS**
**06560 Valbonne (FR)**

(72) Inventeurs:
• **CHMIELOWSKI, Radoslaw**
**06250 Mougins (FR)**
• **PERE, Daniel**
**06800 Cagnes Sur Mer (FR)**
• **JACOB, Stéphane**
**06160 Juan Les Pins (FR)**
• **DENNLER, Gilles**
**06550 La Roquette Sur Siagne (FR)**
• **BHATTACHARYA, Sandip**
**40233 Düsseldorf (DE)**
• **MADSEN, Georg**
**1220 Wien (AT)**

(74) Mandataire: **Berger, Helmut**
**Cabinet Weinstein**
**176 avenue Charles de Gaulle**
**92200 Neuilly sur Seine (FR)**

(56) Documents cités:
• **R. CHMIELOWSKI ET AL: "High thermoelectric performance of tellurium doped paracostibite", JOURNAL OF MATERIALS CHEMISTRY C: MATERIALS FOR OPTICAL AND ELECTRONIC DEVICES, vol. 4, no. 15, 10 février 2016 (2016-02-10), pages 3094-3100, XP055270948, UK ISSN: 2050-7526, DOI: 10.1039/C6TC00410E**
• **BO DUAN ET AL: "Thermoelectric performance of tellurium and sulfur double-substituted skutterudite materials", JOURNAL OF MATERIALS SCIENCE, vol. 49, no. 13, 19 mars 2014 (2014-03-19), pages 4445-4452, XP055270903, Dordrecht ISSN: 0022-2461, DOI: 10.1007/s10853-014-8141-3**
• **CARLINI R ET AL: "Synthesis and characterisation of the compound CoSbS", JOURNAL OF THERMAL ANALYSIS AND CALORIMETRY, KLUWER ACADEMIC PUBLISHERS, DORDRECHT, NL, vol. 103, no. 1, 30 septembre 2010 (2010-09-30), pages 23-27, XP019879739, ISSN: 1572-8943, DOI: 10.1007/S10973-010-1034-Z**
• **ZIHANG LIU ET AL: "The effect of nickel doping on electron and phonon transport in the n-type nanostructured thermoelectric material CoSbS", JOURNAL OF MATERIALS CHEMISTRY C: MATERIALS FOR OPTICAL AND ELECTRONIC DEVICES, vol. 3, no. 40, 3 juillet 2015 (2015-07-03), pages 10442-10450, XP055270957, UK ISSN: 2050-7526, DOI: 10.1039/C5TC01560J**

**Description**

L'invention concerne principalement un matériau thermoélectrique à base de sulfure de cobalt et d'antimoine qui est dopé de type n par du tellure.

L'effet thermoélectrique est un phénomène physique présent dans certains matériaux qui lie le flux de chaleur qui les traverse à la puissance électrique qui les parcourt.

Les matériaux thermoélectriques ont ainsi la double capacité de générer une puissance électrique lorsqu'ils sont exposés à un gradient de température (effet Seebeck), et de générer un flux de chaleur lorsqu'un courant électrique leur est appliqué dans la masse (effet Peltier).

Les performances des matériaux thermoélectriques dépendent de la gamme de température dans lesquelles ils sont utilisés.

Pour une plage de température dite moyenne de 0 à 400°C environ, un matériau thermoélectrique efficace connu est composé de tellure de bismuth de formule $Bi_xTe_y$.

Mais le tellure est un matériau rare dont le prix élevé est soumis à d'importantes fluctuations. Il est donc important de développer des matériaux thermoélectriques qui ne sont pas élaborés à base de cet élément.

Matériaux du type CoSbS sont connus de J. Therm. Anal. Calorim. (2011) 103:23-27 et J. Mater. Chim. C (2015) 3, 10442-10450.

Dans ce contexte, la présente invention vise un matériau thermoélectrique composé d'éléments abondants de plus faible coût, et suffisamment efficace pour la gamme de température moyenne précitée. Le matériau thermoélectrique devra en outre être un semi-conducteur et devra avoir un grand nombre de porteurs de charge.

À cet effet, le composé thermoélectrique de l'invention est à base de sulfure de cobalt et d'antimoine qui est dopé de type n par du tellure positionné sur le site de l'antimoine.

Le composé thermoélectrique de l'invention peut également comporter les caractéristiques optionnelles suivantes considérées isolément ou selon toutes les combinaisons techniques possibles :

- le sulfure de cobalt et d'antimoine est en sous-stoechiométrie d'antimoine.
- le pourcentage atomique d'antimoine retiré est égal au pourcentage atomique de tellure ajouté, les pourcentages atomiques étant considérés par rapport à l'antimoine présent dans le sulfure de cobalt et d'antimoine en stoechiométrie.
- le pourcentage atomique de tellure par rapport à l'antimoine présent dans le sulfure de cobalt et d'antimoine en stoechiométrie est compris entre 2 et 6.
- le pourcentage atomique de tellure dans le sulfure de cobalt et d'antimoine est de 4.
- le composé présente une structure cristalline orthorhombique.
- le composé est en outre dopé par du nickel, du palladium et/ou du platine, lequel dopant est positionné sur le site du cobalt.
- l'élément dopant est du palladium.
- le pourcentage atomique du palladium par rapport au cobalt présent dans le sulfure de cobalt et d'antimoine en stoechiométrie est compris entre 0,2 et 3.

D'autres caractéristiques et avantages de l'invention ressortiront clairement de la description qui en est donnée ci-dessous, à titre indicatif et nullement limitatif, en référence aux figures annexées parmi lesquelles :

- la figure 1 est un graphique représentant l'évolution linéaire du paramètre de maille a de la structure cristalline du sulfure de cobalt et d'antimoine en fonction du pourcentage atomique de tellure ajouté,
- la figure 2 est un graphique représentant l'évolution linéaire du paramètre de maille b de la structure cristalline du sulfure de cobalt et d'antimoine en fonction du pourcentage atomique de tellure ajouté,
- la figure 3 est un graphique représentant l'évolution linéaire du paramètre de maille c de la structure cristalline du sulfure de cobalt et d'antimoine en fonction du pourcentage atomique de tellure ajouté,
- la figure 4 est un graphique comparant l'évolution du facteur de puissance selon la température pour du sulfure de cobalt et d'antimoine dopé à 2 et 4 pour cent atomique par du tellure, et l'évolution du facteur de puissance du sulfure de cobalt et d'antimoine non dopé,
- la figure 5 est un graphique comparant l'évolution du facteur de puissance selon le pourcentage atomique de tellure dans le sulfure de cobalt et d'antimoine en stoechiométrie d'antimoine et en sous-stoechiométrie d'antimoine pour une température de 60°C et pour une gamme de température comprise entre 250°C et 400°C plus élevée conférant un facteur de puissance maximum, et
- la figure 6 est un graphique comparant l'évolution du facteur de puissance selon la température pour du sulfure de cobalt et d'antimoine dopé à 4% atomique par du tellure avec et sans codopage au palladium.

Dans la description qui suit, la référence au pourcentage atomique des différents dopants cités s'entend par le pourcentage d'atome de ce dopant par rapport au nombre d'atomes de l'élément sur lequel est positionné le dopant lorsque cet élément est présent dans le sulfure de cobalt et d'antimoine en stoechiométrie, c'est-à-dire le sulfure de cobalt et d'antimoine de départ.

L'invention se rapporte principalement à un composé thermoélectrique à base de sulfure de cobalt et d'antimoine (CoSbS) dopé de type n sur le site de l'antimoine par du tellure. Le composé thermoélectrique peut également être codopé sur le site du cobalt par du nickel, du palladium et/ou du platine.

Un matériau thermoélectrique est caractérisé par sa figure de mérite ZT qui s'exprime de la façon suivante :

$$ZT = \frac{S^2 \sigma T}{\kappa} \qquad (1)$$

Ou S est le coefficient de Seebeck $\mu V.K^{-1}$)
$\sigma$ est la conductivité électrique $(S.m^{-1})$
k est la conductivité thermique $(W.K^{-1}.m^{-1})$
T la température (K)

La figure de mérite ZT peut également s'exprimer de la façon suivante :

$$ZT = \frac{S^2 T}{\rho \kappa} \qquad (2)$$

Ou p est la résistivité électrique (en $\Omega.m$)

Le facteur de mérite ZT a été conçu pour comparer les performances des matériaux thermoélectriques utilisés dans le mode Peltier. Dans le cas de l'utilisation de matériaux thermoélectriques dans le mode Seebeck, c'est-à-dire pour la génération de puissance électrique à partir d'un gradient de température, les performances des matériaux électriques peuvent être illustrées par un facteur de puissance PF qui s'exprime de la façon suivante :

$$PF = S^2 . \ \sigma = S^2 . \rho^1 \qquad (3)$$

Dans les exemples ci-dessous, les performances des matériaux thermoélectriques de l'invention sont ainsi caractérisées par leur facteur de puissance PF.

On décrit ci-après un exemple de réalisation non limitatif du composé thermoélectrique de l'invention.

La préparation du composé thermoélectrique CoSbS de l'invention est réalisée en deux étapes. La première étape consiste à réaliser la synthèse du CoSbS dans une ampoule en quartz (AQ), puis la seconde étape à compacter le CoSbS obtenu à l'issue de la première étape par une méthode de frittage également dénommée par le terme anglophone « Spark Plasma Sintering (SPS) ».

Pour synthétiser le CoSbS dopé avec différents dopants, les poudres de cobalt, d'antimoine, de soufre et du dopant tel que le tellure, le cobalt, le nickel, le palladium et le platine sont pesées pour obtenir le taux de dopage souhaité.

Les quantités de poudre requises sont ensuite mélangées dans un mortier en agate pour obtenir des mélanges homogènes. Les mélanges résultants sont placés dans des ampoules en quartz qui sont scellées sous vide.

Les ampoules scellées sont alors chauffées pour atteindre la température de 923K, soit environ 650°C, et maintenues à cette température pendant 48h. Puis ces ampoules sont refroidies jusqu'au retour à la température ambiante.

Pour préparer des pastilles par SPS, les poudres refroidies sont broyées et passées à travers des tamis avec une ouverture de maille de 150 $\mu$m pour obtenir des poudres présentant des tailles de particules homogènes. Ces poudres sont alors placées dans un moule cylindrique entre deux pistons. Le diamètre interne du moule est de 10,5 millimètres et les pistons ont un diamètre de 10 millimètres. La différence de 0,5 millimètres entre le diamètre interne du moule et le diamètre du piston permet l'addition d'une feuille de graphite entre la poudre et les pistons d'une part et le moule d'autre part. Cette feuille de graphite supplémentaire sert à protéger le moule dans le cas où la poudre réagirait avec le moule. Ces feuilles de graphite sont aussi ajoutées sur les faces des pistons en contact avec la poudre. Sans ces feuilles de graphite, les pastilles préparées colleraient aux pistons après le frittage et il ne serait pas possible de les séparer.

La quantité de poudre ajoutée lors d'un compactage par SPS est choisie de telle sorte que ce compactage aboutisse à une pastille d'une hauteur d'environ 2,5 millimètres.

Le moule contenant la poudre est placé dans la chambre SPS. L'air est évacué de la chambre jusqu'à ce qu'un vide secondaire d'environ $10^{-2}$ Pascal soit atteint.

Une pression de 50 MPa est ensuite appliquée sur les deux pistons avant de démarrer le frittage.

Le frittage est réalisé en chauffant d'abord la poudre jusque 575°C avec vitesse d'augmentation de la température de 100°C/min. Une fois la température de 575°C atteinte, cette température est maintenue pendant 15 minutes.

Pour finir, le voltage et le courant ont été arrêtés pour permettre à l'échantillon de refroidir lentement jusqu'à la température ambiante. La surface des pastilles obtenues est ensuite polie pour être nettoyée.

La structure cristalline du CoSbS dopé au tellure est caractérisée par cristallographie aux rayons X. Des mesures comparatives sont réalisées pour du CoSbS dopé à 0,5, 2, 4 et 8 pour cent atomique de tellure par rapport à l'antimoine présent dans le sulfure de cobalt et d'antimoine en stoechiométrie. On constate que pour ces pourcentages atomiques de tellure, la structure cristalline orthorhombique du CoSbS dopé est conservée.

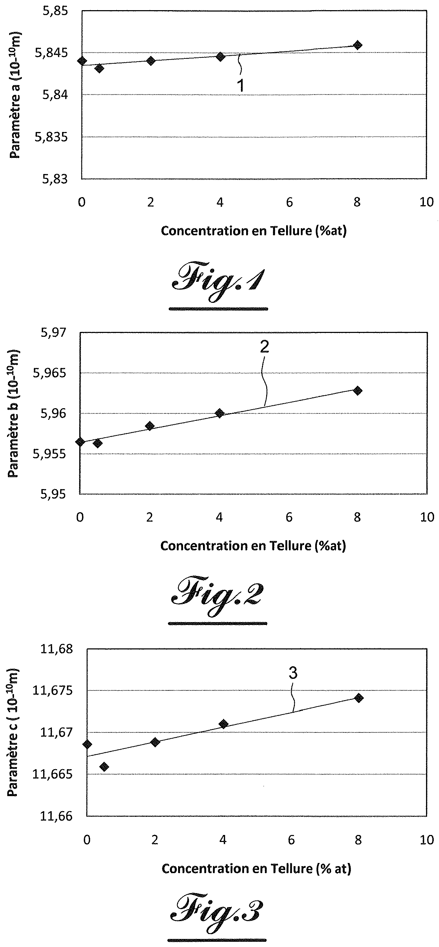

En référence aux figures 1 à 3, les paramètres de maille a, b et c de la structure cristalline du CoSbS sont évalués pour du CoSbS non dopé et du CoSbS dopé aux quatre pourcentages atomiques de tellure précités. L'évolution du paramètre de maille a est caractérisé par la courbe 1 de la figure 1, l'évolution du paramètre de maille b est caractérisé par la courbe 2 de la figure 2 et l'évolution du paramètre de maille c est caractérisé par la courbe 3 de la figure 3.

On observe une augmentation quasi linéaire des trois paramètres de maille avec l'augmentation du pourcentage atomique de tellure, ce qui met en évidence la présence d'une solution solide dans la structure cristalline orthorhombique du CoSbS et confirme la réalisation du dopage.

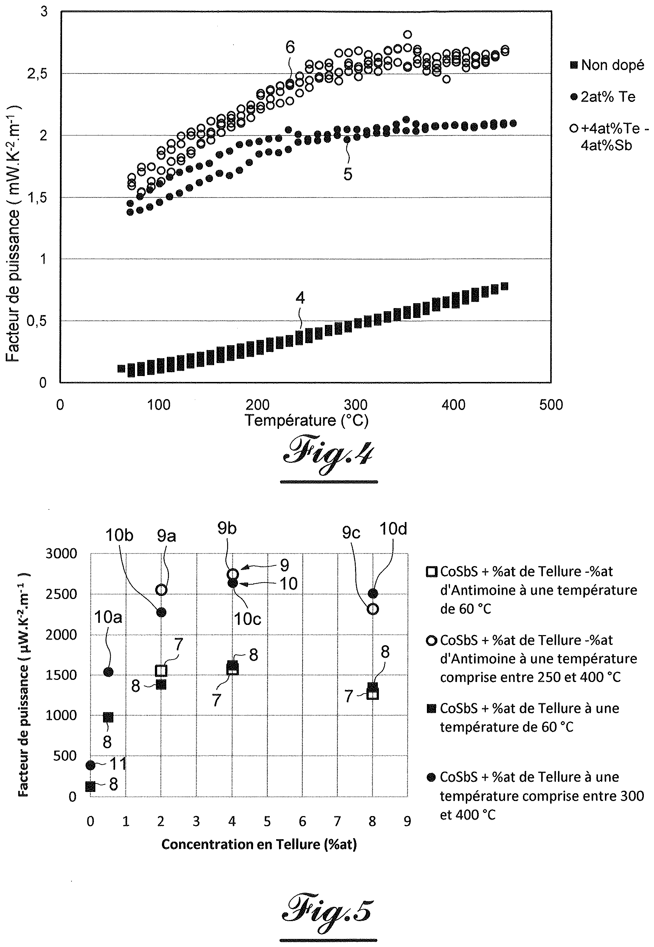

On se réfère à présent à la figure 4 qui représente l'évolution du facteur de puissance pour du CoSbS non dopé (courbe de points 4), pour du CoSbS dopé à 2 pour cent atomique de tellure (courbe de points 5) et pour du CoSbS dopé à 4 pour cent atomique de tellure avec une sous-stoechiométrie en antimoine de 4 pour cent atomique également.

Le pourcentage atomique de tellure ajouté et le pourcentage atomique d'antimoine retiré est préférentiellement égal pour optimiser l'insertion du tellure dans la structure cristalline du CoSbS.

On constate une augmentation substantielle des performances du CoSbS dopé au tellure quadruplant ces performances par rapport au CoSbS non volontairement dopé à 300°C pour un dopage de 2 pour cent atomique de tellure et les quintuplant pour un dopage à 4 pour cent atomique.

La figure 5 confirme ces résultats.

Les points référencés 7 illustrent l'évolution du facteur de puissance à 60°C du CoSbS dopé au tellure avec une sous-stoechiométrie en antimoine de pourcentage atomique égal au pourcentage atomique de tellure ajouté, en fonction du pourcentage atomique de tellure ajouté.

Les points référencés 8 illustrent l'évolution du facteur de puissance à 60°C du CoSbS dopé au tellure sans sous-stoechiométrie en antimoine, en fonction du pourcentage atomique de tellure. Le maximum obtenu pour une concentration en tellure de 4 pour cent atomique est de 1621 $\mu$W.K$^{-2}$.m$^{-1}$.

Les points références 9 qui présentent un facteur de puissance nettement plus élevé que les points référencés 7 et 8 illustrent l'évolution du facteur de puissance du CoSbS dopé au tellure avec une sous-stoechiométrie en antimoine de pourcentage atomique égal au pourcentage atomique de tellure ajouté, en fonction du pourcentage atomique de tellure ajouté. Les valeurs des facteurs de puissance des points référencés 9 correspondent aux facteurs de puissance maximum obtenus pour des températures variant entre 250°C et 400°C.

Plus précisément, le point 9a correspond à une température de 250°C, le point 9b correspond à une température de 350°C et le point 9c correspond à une température de 397°C. Le maximum obtenu pour une concentration en tellure de 4% atomique est de 2745 $\mu$W.K$^{-2}$.m$^{-1}$.

Enfin, les points référencés 10 illustrent l'évolution du facteur de puissance du CoSbS dopé au tellure sans sous-stoechiométrie en antimoine en fonction du pourcentage atomique de tellure. Les valeurs des points référencés 10 correspondent aux facteurs de puissance maximum obtenus pour des températures variant entre 300°C et 400°C environ.

Plus précisément, le point 10a correspond à une température de 300°C, le point 10b correspond à une température de 320°C, le point 10c correspond à une température de 372°C et le point 10c correspond à une température de 371°C.

Le point 11 illustrant le facteur de puissance du CoSbS non dopé est pris à une température de 258°C.

On constate que quel que soit le critère considéré c'est à dire une température fixe de 60°C ou un facteur de puissance maximum, les performances maximum sont obtenues pour un pourcentage atomique de tellure qui avoisine les 4 pour cent atomique. On définit ainsi qu'un facteur de puissance maximum est obtenu lorsque le pourcentage atomique de tellure est compris entre 2 et 6 pour cent atomique, de préférence de 4 pour cent atomique.

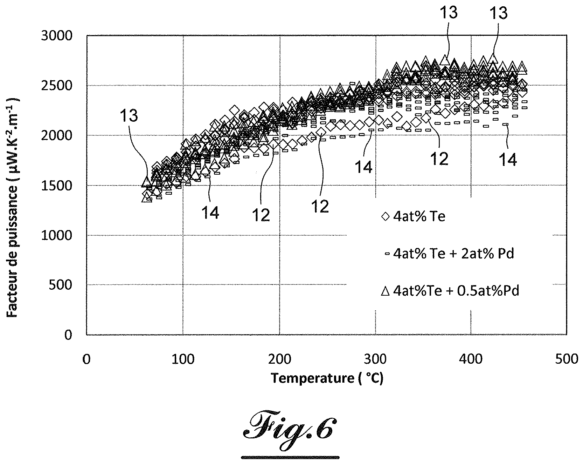

La figure 6 illustrent les résultats obtenus lorsque le CoSbS est dopé par du tellure à une teneur de 4 pour cent atomique sur le site de l'antimoine et également dopé par du palladium sur le site du cobalt.

Les points 12 illustrent les performances du CoSbS uniquement dopé au tellure en fonction de la température.

Les points 13 illustrent les performances du CoSbS dopé au tellure et à 0,5 pour cent atomique de palladium. Enfin les points 14 illustrent les performances du CoSbS dopé au tellure et à 2 pour cent atomique de palladium.

On constate qu'un codopage sur le site du cobalt par le palladium permet de maintenir les hautes performances obtenues par le dopage du tellure.

L'invention couvre ainsi également un codopage sur le site du cobalt. Si seul le codopage au palladium est illustré sur la figure 6, des performances équivalentes avec d'autres éléments voisins du cobalt, à savoir par exemple du nickel et du platine, permettent d'obtenir des résultats similaires. Ces résultats ont été obtenus par des calculs ab-initio basés sur la Théorie de la fonctionnelle de la densité (DFT) et s'expliquent par le fait que ces différents éléments de codopage sont de structure électronique proche.

Les applications de ce composé thermoélectrique sont nombreuses. On citera notamment son emploi dans le corps humain, la construction, les centrales, les usines, les véhicules et dans tout type d'appareil et d'appareillage où existe un flux de chaleur ou un gradient thermique.

**Revendications**

1. Composé thermoélectrique à base de sulfure de cobalt et d'antimoine qui est dopé de type n par du tellure positionné sur le site de l'antimoine.

2. Composé thermoélectrique selon la revendication 1, **caractérisé en ce que** le sulfure de cobalt et d'antimoine est en sous-stoechiométrie d'antimoine.

3. Composé thermoélectrique selon la revendication 2, **caractérisé en ce que** le pourcentage atomique d'antimoine retiré est égal au pourcentage atomique de tellure ajouté, les pourcentages atomiques étant considérés par rapport à l'antimoine présent dans le sulfure de cobalt et d'antimoine en stoechiométrie.

4. Composé thermoélectrique selon l'une quelconque des revendications 1 à 3, **caractérisé en ce que** le pourcentage atomique de tellure par rapport à l'antimoine présent dans le sulfure de cobalt et d'antimoine en stoechiométrie est compris entre 2 et 6.

5. Composé thermoélectrique selon la revendication 4, **caractérisé en ce que** le pourcentage atomique de tellure dans le sulfure de cobalt et d'antimoine est de 4.

6. Composé thermoélectrique selon l'une quelconque des revendications précédentes, **caractérisé en ce qu'**il présente une structure cristalline orthorhombique.

7. Composé thermoélectrique selon l'une quelconque des revendications précédente, **caractérisé en ce qu'**il est en outre dopé par du nickel, du palladium et/ou du platine, lequel dopant est positionné sur le site du cobalt.

8. Composé thermoélectrique selon la revendication 7, **caractérisé en ce que** l'élément dopant est du palladium.

9. Composé thermoélectrique selon la revendication 9, **caractérisé en ce que** le pourcentage atomique du palladium par rapport au cobalt présent dans le sulfure de cobalt et d'antimoine en stoechiométrie est compris entre 0,2 et 3.

**Patentansprüche**

1. Thermoelektrische Zusammensetzung auf der Basis von Sulfid von Kobalt und Antimon, das von auf der Antimonstelle positioniertem Tellur n-dotiert ist.

2. Thermoelektrische Zusammensetzung nach Anspruch 1, **dadurch gekennzeichnet, dass** das Sulfid von Kobalt und Antimon antimon-unterstoechiometrisch ist.

3. Thermoelektrische Zusammensetzung nach Anspruch 2, **dadurch gekennzeichnet, dass** der Atomprozentsatz entfernten Antimons gleich dem Atomprozentsatz hinzugefügten Tellurs ist, wobei die Atomprozentsätze in Bezug auf das im stoechiometrischen Sulfid von Kobalt und Antimon vorhandenen Antimon betrachtet werden.

4. Thermoelektrische Zusammensetzung nach einem der Ansprüche 1 bis 3, **dadurch gekennzeichnet, dass** der Atomprozentsatz von Tellur in Bezug auf Antimon, vorhanden im stoechiometrischen Sulfid von Kobalt und Antimon, zwischen 2 und 6 liegt.

5.  Thermoelektrische Zusammensetzung nach Anspruch 4, **dadurch gekennzeichnet, dass** der Atomprozentsatz von Tellur im Sulfid von Kobalt und Antimon 4 beträgt.

6.  Thermoelektrische Zusammensetzung nach einem der vorangehenden Ansprüche, **dadurch gekennzeichnet, dass** sie eine orthorombische kristalline Struktur aufweist.

7.  Thermoelektrische Zusammensetzung nach einem der vorangehenden Ansprüche, **dadurch gekennzeichnet, dass** sie ferner durch Nickel, durch Palladium und/oder durch Platin dotiert ist, wobei das Dotierungsmittel auf der Kobaltstelle positioniert ist.

8.  Thermoelektrische Zusammensetzung nach Anspruch 7, **dadurch gekennzeichnet, dass** das dotierende Element Palladium ist.

9.  Thermoelektrische Zusammensetzung nach Anspruch 9, **dadurch gekennzeichnet, dass** der Atomprozentsatz des Palladiums in Bezug auf Kobalt, vorhanden im stoechiometrischen Sulfid von Kobalt und Antimon, zwischen 0,2 und 3 liegt.

**Claims**

1.  Thermoelectric compound based on cobalt and antimony sulphide, that is n-type doped with tellurium positioned at the antimony site.

2.  The thermoelectric compound according to claim 1, **characterized in that** the cobalt and antimony sulphide has antimony sub-stoichiometry.

3.  The thermoelectric compound according to claim 2, **characterized in that** the atomic percentage of removed antimony is equal to the atomic percentage of added tellurium, the atomic percentages being considered in relation to antimony contained in the cobalt and antimony sulphide in stoichiometry

4.  The thermoelectric compound according to any of claims 1 to 3, **characterized in that** the atomic percentage of tellurium relative to the antimony contained in the cobalt and antimony sulphide in stoichiometry is between 2 and 6.

5.  The thermoelectric compound according to claim 4, **characterized in that** the atomic percentage of tellurium in the cobalt and antimony sulphide is 4.

6.  The thermoelectric compound according to any of the preceding claims, **characterized in that** it has an orthorhombic crystalline structure.

7.  The thermoelectric compound according to any of the preceding claims, **characterized in that** it is also doped with nickel, palladium and/or platinum, said dopant being positioned at the cobalt site.

8.  The thermoelectric compound according to claim 7, **characterized in that** the dopant element is palladium.

9.  The thermoelectric compound according to claim 9, **characterized in that** the atomic percentage of palladium relative to cobalt contained in the cobalt and antimony sulphide in stoichiometry is between 0.2 and 3.

*Fig.1*

*Fig.2*

*Fig.3*

*Fig.4*

*Fig.5*

*Fig.6*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- *J. Therm. Anal. Calorim.,* 2011, vol. 103, 23-27
- *J. Mater. Chim. C,* 2015, vol. 3, 10442-10450